Europäisches Patentamt

European Patent Office

Office européen des brevets

(19)

(11) Veröffentlichungsnummer: **0 065 765**
**A1**

## (12) EUROPÄISCHE PATENTANMELDUNG

(21) Anmeldenummer: 82104435.1

(22) Anmeldetag: 19.05.82

(51) Int. Cl.³: **H 05 K 3/00**

(30) Priorität: 19.05.81 DE 3119884

(43) Veröffentlichungstag der Anmeldung:
01.12.82 Patentblatt 82/48

(84) Benannte Vertragsstaaten:
AT BE CH FR GB IT LI NL SE

(71) Anmelder: FRITZ WITTIG Herstellung gedruckter
Schaltungen
Konrad-Celtis-Strasse 81
D-8000 München 70(DE)

(72) Erfinder: Steinberger, Joachim
Rheinstrasse 31
D-8000 München 40(DE)

(72) Erfinder: Dähler, Wilfried
Gräfelfinger Strasse 92
D-8000 München 70(DE)

(72) Erfinder: Baumann, Klaus
Fliederweg 1
D-8000 München 90(DE)

(72) Erfinder: Rohde, Dietmar
Brennerstrasse 83
D-8031 Gröbenzell(DE)

(72) Erfinder: Niedermeier, Roland, Dipl.-Ing.
Steeg Nr.1
D-8251 Buchbach(DE)

(72) Erfinder: Lehmann, Heinz, Ing.grad.
Nelkenweg 11
D-8028 Taufkirchen(DE)

(74) Vertreter: Finck, Dieter et al,
Patentanwälte v. Füner, Ebbinghaus, Finck
Mariahilfplatz 2 & 3
D-8000 München 90(DE)

(54) **Verfahren zur Herstellung von starre und flexible Bereiche aufweisenden Leiterplatten.**

(57) Zur Herstellung von starre und flexible Bereiche aufweisenden Leiterplatten, die mit einer Verbindungsfolie (3) verklebt werden, wird in die später flexiblen Bereiche (2') ein mit der Verbindungsfolie (3) keine Haftverbindung eingehendes Trennmedium (5) aus einem starren plattenförmigen Material, vorzugsweise aus mit Polytetrafluoräthylen beschichtetem Messingblech, eingesetzt, das der Form der späteren flexiblen Bereiche (2') entsprechend durch Ätzen oder Stanzen konturiert ist. Die Verbindungsfolie (3), wenigstens eine flexible, Leiter aufweisende Lage (7) und eine eine starre, verbindungsfolienseitig leiterfreie oder mit Leitern versehene Außenlage (2) werden anschließend zueinander ausgerichtet. Dann wird die Verbindungsfolie (3) mit der flexiblen Lage (1) und der starren Außenlage (2) durch Verpressen verbunden. Nach der Ausbildung von Leitern auf der freien Oberfläche der Außenlage (2) werden schließlich in der Außenlage (2) von ihrer freien Oberfläche ausgehend längs Trennlinien zwischen den starren und flexiblen Bereichen Nuten eingeschnitten, die sich über die ganze Stärke der Außenlage (2) erstrecken.

FIG. 2

PATENTANWÄLTE

**0065765**

SCHIFF v. FÜNER STREHL SCHÜBEL-HOPF EBBINGHAUS FINCK

MARIAHILFPLATZ 2 & 3, MÜNCHEN 90
POSTADRESSE: POSTFACH 95 01 60, D-8000 MÜNCHEN 95

ALSO PROFESSIONAL REPRESENTATIVES
BEFORE THE EUROPEAN PATENT OFFICE

KARL LUDWIG SCHIFF (1964-1978)
DIPL. CHEM. DR. ALEXANDER v. FÜNER
DIPL. ING. PETER STREHL
DIPL. CHEM. DR. URSULA SCHÜBEL-HOPF
DIPL. ING. DIETER EBBINGHAUS
DR. ING. DIETER FINCK

TELEFON (089) 48 20 54
TELEX 5-23 565 AURO D
TELEGRAMME AUROMARCPAT MÜNCHEN

EPA-20836

Verfahren zur Herstellung von starre und
flexible Bereiche aufweisenden Leiterplatten

Die Erfindung betrifft ein Verfahren zur Herstellung von starre und flexible Bereiche aufweisenden Leiterplatten, die mit einer Verbindungsfolie verklebt werden, wobei in die später flexiblen Bereiche ein mit der Verbindungsfolie keine Haftverbindung eingehendes Trennmedium eingesetzt wird, die Verbindungsfolie, wenigstens eine flexible, Leiter aufweisende Lage und eine starre, verbindungsfolienseitig leiterfreie oder mit Leitern versehene Außenlage zueinander ausgerichtet werden, die Verbindungsfolie mit der flexiblen Lage und der starren Außenlage durch Verpressen verbunden wird, auf der freien Oberfläche der Außenlage Leiter ausgebildet werden und dann in der Außenlage von ihrer freien Oberfläche ausgehend längs Trennlinien zwischen den starren und flexiblen Bereichen Nuten eingeschnitten werden.

Es ist bereits bekannt, zur Herstellung von starre und flexible Bereiche aufweisenden Leiterplatten in der starren Außenlage zwei Schlitze auszufräsen und durch diese Schlitze eine Trennfolie hindurchzuführen, so daß sie auf der einen Fläche zwischen den beiden Schlitzen von der Trennfolie abgedeckt ist. Wenn die starre Außenlage mit einer flexiblen, Leiter aufweisenden Lage durch Verkleben verbunden wird, wobei eine Kleberfolie verwendet werden kann, verhindert die Trennfolie, die mit dem Kleber keine Haftverbindung eingeht, eine haftende Verbindung in dem abgedeckten Bereich mit der flexiblen Lage, so daß nach dem Beschneiden des Umrisses der auf diese Weise hergestellten Leiterplatte die Trennfolie und der von ihr zur flexiblen Lage hin abgedeckte Abschnitt der starren Außenlage weggenommen werden können, wodurch an dieser Stelle die flexible Innenlage frei von der starren Außenlage ist und gebogen werden kann (Feinwerktechnik und Meßtechnik, 84 (1976), 317 bis 320).

Bei einem weiteren bekannten Verfahren wird zunächst auf eine flexible, mit Leitern versehene Lage, die mehrschichtig ausgebildet sein kann, eine Verbindungsfolie in Form einer Kleberfolie aufgebracht, die in den Bereichen, in denen die flexible Lage bei der fertigen Leiterplatte frei liegen soll, mit einer entsprechenden Aussparung versehen wird. Aus einem Folienmaterial wird eine dieser Aussparung entsprechende Trennfolie zugeschnitten, in die Aussparung eingelegt und außerhalb der späteren Umrißbeschneidung, beispielsweise mittels eines Klebefilms, fixiert. Anschließend wird auf die Kleberfolie die starre Außenlage aufgelegt, in die auf der der Kleberfolie zugewandten Seite bereits Nuten eingefräst sind, die sich nur über einen Teil der Stärke der Außenlage erstrecken und längs der Trennlinien verlaufen, längs derer die starre Außenlage bei der fertigen Leiterplatte entfernt ist, wobei diese Trennlinien im wesentlichen den Linien entsprechen, an denen die Kleberfolie und die Trennfolie aneinanderstoßen. Die starre Außenlage wird nun bezüglich der flexiblen Lage mit der darauf befindlichen Kleberfolie und Trennfolie so ausgerichtet, daß die Nuten zum Verlauf der Stoßlinien von Trennfolie und Kleberfolie fluchten und, falls erforderlich, eine entsprechende Leiterzuordnung auf der Innenseite der starren Leiterplatte und der flexiblen Lage gewährleistet ist. Nach dem Verpressen der so ausgerichteten Lagen, wodurch eine Verbindung zwischen der flexiblen Innenlage und der starren Außenlage im Bereich der Kleberfolie erfolgt, werden auf der freien Oberfläche der starren Lage weitere Leiter ausgebildet. Von der freien Oberfläche der Außenlage her werden nun in fluchtender Ausrichtung zu den bereits von der anderen Seite her ausgebildeten Nuten weitere Nuten eingeschnitten, und zwar bis auf eine Tiefe, daß die einander zugeordneten Nuten aufeinandertreffen, so daß die entsprechenden Abschnitte der starren Lage und der Trennfolie herausfallen, oder bis zu einer Tiefe, bei welcher ein schmaler Steg zwischen einander zugeordneten Nuten stehenbleibt, so daß die zwischen den Nuten befindlichen Abschnitte der starren Lage herausgebrochen werden können, wodurch nach Entfernen der Trennfolie die flexible Innenlage in dem gewünschten Bereich freiliegt (DE-AS 26 57 212).

Bei dem bekannten Verfahren ist es bei komplizierten Leiterbildern sehr schwierig, in der Kleberfolie die erforderlichen Aussparungen vorzusehen und die flexible Trennfolie entsprechend zuzuschneiden. Weiterhin ist es äußerst aufwendig, zunächst Nuten längs vorgegebener Linien von der einen Seite der starren Lage vor der Herstellung der Preßverbindung mit der flexiblen Lage auszubilden und später längs der gleichen Linien von der freien Oberfläche der starren Außenlage entsprechende Nuten einzuschneiden, nur um auf diese Weise ein Durchschneiden der dünnen Trennfolie in die flexible Innenlage zu verhindern. Schließlich hat es sich als nachteilig erwiesen, daß bei den während des Verpressens herrschenden Temperaturen die Trennfolie flüchtige Bestandteile in Form von Gasen oder Dämpfen abgibt, die in der Leiterplatte eingeschlossen bleiben.

Die der Erfindung zugrunde liegende Aufgabe besteht deshalb darin, das Verfahren der eingangs genannten Art so auszubilden, daß die Leiterplatten mit einem erheblich reduzierten Herstellungsaufwand produziert werden können.

Gelöst wird diese Aufgabe ausgehend von dem Verfahren der eingangs genannten Art dadurch, daß als Trennmedium ein starres plattenförmiges Material den flexiblen Bereichen entsprechend konturiert wird und die Nuten wenigstens durch die gesamte Stärke der Außenlage gehend ausgebildet werden.

Dabei kann das das Trennmedium bildende starre Material zur Verhinderung der Haftverbindung mit der angrenzenden Verbindungsfolie mit einer Substanz beschichtet sein, die aufgesprüht werden kann und vorzugsweise aus Polytetrafluoräthylen besteht.

Als starres plattenförmiges Material eignet sich einerseits besonders Blech, insbesondere Messingblech, dessen Konturen durch Ätzen sehr genau und äußerst einfach gefertigt werden können. Es kann jedoch auch ein entsprechend starrer Kunststoff benutzt werden, der sich durch Stanzen konturieren läßt.

Das erfindungsgemäße Verfahren hat den Vorteil, daß nur einmal Nuten eingeschnitten zu werden brauchen, und zwar von der freien Oberfläche der starren Lage durch die ganze Stärke dieser Lage hindurchgehend, wobei eine genaue Schnittiefe nicht eingehalten zu werden braucht, da ein Einschneiden in das starre Material zulässig ist und durch dieses beginnende Einschneiden sofort erkennbar wird, daß das starre Material weit genug durchschnitten ist, so daß der Abschnitt zwischen den Nuten und das darunter liegende Trennmedium entfernt werden können, wobei ein Durchschneiden des starren Materials aufgrund seiner Dicke nicht zu befürchten ist. Eine Anpassung der Stärke des starren Materials an die verwendete Stärke der Verbindungsfolie ist ohne weiteres möglich, da die verwendeten Bleche und Kunststoffe in einer Vielzahl von Stärken innerhalb der erforderlichen Bereiche handelsüblich sind. Weiterhin ist vorteilhaft, daß die Konturierung des starren Materials entsprechend den Aussparungen in der Verbindungsfolie durch Ätzen oder Stanzen äußerst einfach durchgeführt werden kann und die Positionierung aufgrund der Starrheit einfach ist, wobei das starre Material über die flexiblen Bereiche in den später abzuschneidenden Umrißbereich geführt und zusammen mit den Lagen mit Hilfe von Referenzlöchern in der gewünschten Zuordnung ohne weiteres positioniert werden kann, wobei nach diesem Positionieren ein Verrutschen, also ein Verlorengehen der Zuordnung ausgeschlossen bleibt. Gleichzeitig wird auf diese Weise ein falsches Einlegen des das Trennmedium bildenden starren Materials verhindert. Schließlich hat sich noch gezeigt, daß bei Verwendung von mit Polytetrafluoräthylen beschichtetem Blech als Trennmedium beim Verpressen auch unter sehr hohen Temperaturen keinerlei Ausgasung auftritt.

Anhand der Zeichnung wird die Erfindung beispielsweise näher
erläutert. Es zeigt:

Fig. 1     eine Draufsicht auf eine Ausführungsform einer
           Leiterplatte,

Fig. 2     den Schnitt II-II von Fig. 1 vor dem Verpressen und

Fig. 3     den Schnitt II-II von Fig. 1 nach dem Verpressen.

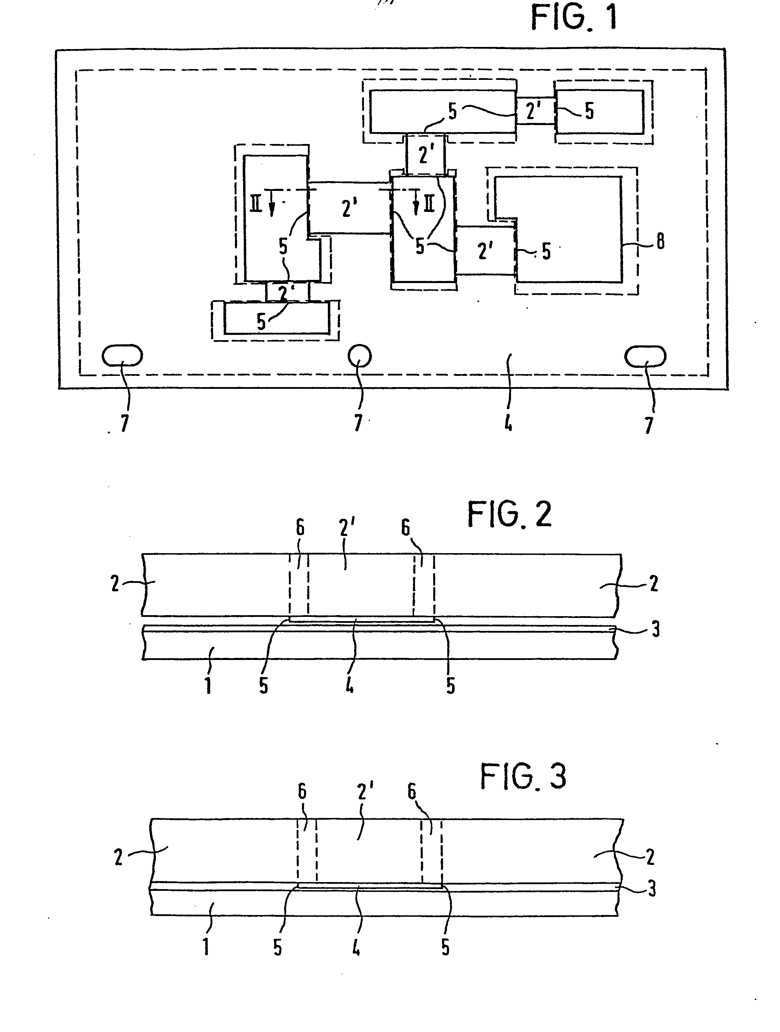

Wie aus Fig. 2 zu ersehen ist, ist auf einer flexiblen Lage 1
mit nicht gezeigten Leitern eine Verbindungsfolie 3 angeordnet,
auf der ein mit Polytetrafluoräthylen beschichtetes Blech 4 angeordnet ist, dessen Stärke der Kleberdicke der Verbindungsfolie 3 angepaßt ist. Die Kontur des Blechs 4 ist durch
Ätzen hergestellt und entspricht der Form der vorzusehenden
flexiblen Bereiche.

Wie aus Fig. 1 zu ersehen ist, hat das Blech 4 einen Ansatz,
in dem Positionieröffnungen 7 ausgebildet sind, die so vorgesehen sind, daß bei Ausrichtung zu entsprechenden Positionieröffnungen 7 in der flexiblen Lage 1 und der starren Lage 2 das
Blech 4 sich in genauer Zuordnung zu den auszubildenden flexiblen Bereichen zwischen den Trennlinien 5 von Fig. 2 befindet.
Nach dem Verpressen der flexiblen Lage 1 mit der starren Lage 2
im Bereich der Verbindungsfolie 3, wobei durch das Blech 4
ein Verkleben über die Trennlinien 5 verhindert wird, und
nach dem Ausbilden von Leiterbahnen auf der freien Oberfläche der starren Lage 2 und der Herstellung von vertikalen
nicht gezeigten Leiterverbindungen zwischen der starren Lage 2
und der flexiblen Lage 1, werden von der freien Oberfläche der
starren Lage 2 her Nuten 6 eingeschnitten, deren Außenränder
mit den Trennlinien 5 fluchten. Die Nuten 6 erstrecken sich
über die ganze Stärke der starren Lage 2, wobei die Nuten 6
sich auch in die Oberfläche des darunter befindlichen Blechs 4
erstrecken können. Nach der Ausführung der Nuten 6 längs der Trennlinien 5 liegt der Abschnitt 2' der starren Lage 2 frei und kann zusammen mit dem Blech 4 entfernt werden, so daß nur noch die in Fig. 1 gezeigte Leiterplatte 8 übrigbleibt, die sechs Abschnitte der starren Lage 2 und eine durchgehende flexible Lage 1 aufweist.

Die flexible Lage 1 kann aus einer mit Leitern bestückten Einzellage oder aus einem Verbund von mehreren Einzellagen bestehen, von denen jede mit Leitern versehen ist. Die starre Lage 2 kann vor dem Verpressen auf ihrer der Verbindungsseite zugewandten Seite ebenfalls mit Leitern versehen sein. In gleicher Weise kann, wie beschrieben auf der freien Seite der flexiblen Lage eine weitere starre Lage aufgebracht werden, wobei Abschnitte der flexiblen Lage 1 in der gleichen Weise freigelegt werden.

PATENTANWÄLTE

SCHIFF v. FÜNER STREHL SCHÜBEL-HOPF EBBINGHAUS FINCK

0065765

MARIAHILFPLATZ 2 & 3, MÜNCHEN 90
POSTADRESSE: POSTFACH 95 01 60, D-8000 MÜNCHEN 95

ALSO PROFESSIONAL REPRESENTATIVES
BEFORE THE EUROPEAN PATENT OFFICE

KARL LUDWIG SCHIFF (1964-1978)
DIPL. CHEM. DR. ALEXANDER v. FÜNER
DIPL. ING. PETER STREHL
DIPL. CHEM. DR. URSULA SCHÜBEL-HOPF
DIPL. ING. DIETER EBBINGHAUS
DR. ING. DIETER FINCK

TELEFON (089) 48 20 54
TELEX 5-23 565 AURO D
TELEGRAMME AUROMARCPAT MÜNCHEN

-8-

## Patentansprüche

1. Verfahren zur Herstellung von starre und flexible Bereiche aufweisenden Leiterplatten, die mit einer Verbindungsfolie verklebt werden, wobei in die später flexiblen Bereiche ein mit der Verbindungsfolie keine Haftverbindung eingehendes Trennmedium eingesetzt wird, die Verbindungsfolie, wenigstens eine flexible, Leiter aufweisende Lage und eine starre, verbindungsfolienseitig leiterfreie oder mit Leitern versehene Außenlage zueinander ausgerichtet werden, die Verbindungsfolie mit der flexiblen Lage und der starren Außenlage durch Verpressen verbunden wird, auf der freien Oberfläche der Außenlage Leiter ausgebildet werden und dann in der Außenlage von ihrer freien Oberfläche ausgehend längs Trennlinien zwischen den starren und flexiblen Bereichen Nuten eingeschnitten werden,

d a d u r c h  g e k e n n z e i c h n e t, daß als

Trennmedium ein starres plattenförmiges Material
der Form der flexiblen Bereiche entsprechend
konturiert wird und die Nuten wenigstens durch die
gesamte Stärke der Außenlage gehend ausgebildet werden.

2. Verfahren nach Anspruch 1, d a d u r c h   g e k e n n -
z e i c h n e t, daß das das Trennmedium bildende starre
Material mit einer mit der Verbindungsfolie keine Haftverbindung eingehenden Substanz beschichtet wird.

3. Verfahren nach Anspruch 2, d a d u r c h   g e k e n n -
z e i c h n e t, daß die Substanz auf das das Trennmedium
bildende starre Material aufgesprüht wird.

4. Verfahren nach Anspruch 2 oder 3, d a d u r c h
g e k e n n z e i c h n e t, daß als Substanz für die
Beschichtung des das Trennmedium bildenden starren
Materials Polytetrafluoräthylen verwendet wird.

5. Verfahren nach einem der Ansprüche 1 bis 4, d a d u r c h
g e k e n n z e i c h n e t, daß als das das Trennmedium
bildende starre Material Blech verwendet wird.

6. Verfahren nach Anspruch 5, d a d u r c h   g e k e n n -
z e i c h n e t, daß Messingblech verwendet wird.

7. Verfahren nach Anspruch 5 oder 6, d a d u r c h
g e k e n n z e i c h n e t, daß das Blech durch Ätzen
konturiert wird.

8. Verfahren nach einem der Ansprüche 1 bis 5, d a -
d u r c h   g e k e n n z e i c h n e t, daß als das
das Trennmaterial bildende starre Material Kunststoff
verwendet wird.

9. Verfahren nach Anspruch 8, d a d u r c h   g e k e n n -
   z e i c h n e t,  daß der Kunststoff durch Stanzen konturiert
   wird.

1/1

FIG. 1

FIG. 2

6      2'      6

2                                    2

3

1      5      4      5

FIG. 3

6      2'      6

2                                    2

3

1      5      4      5

Europäisches
Patentamt

**EUROPÄISCHER RECHERCHENBERICHT**

Nummer der Anmeldung

EP 82 10 4435

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A,D | DE-A-2 657 212 (SCHOELLER & CO. ELEKTRONIK GmbH)<br><br>--- | | H 05 K 3/00 |
| A,D | FEINWERKTECHNIK UND MESSTECHNIK, Band 84, Heft 7, Veröffentlicht im Oktober/November 1976, Seiten 317-320, München RDA (DE); D.ACKERMANN et al.: "Starr-flexible Mehrlagenleiterplatten: - Dreidimensionale Gedruckte Schaltungen ermöglichen eine weitere Miniaturisierung und erhöhen die Zuverlässigkeit"<br><br>--- | | |
| A | US-A-4 026 011 (BURROUGHS CORP)<br><br>----- | | |
| | | | **RECHERCHIERTE SACHGEBIETE (Int. Cl. ³)**<br><br>H 05 K |

Der vorliegende Recherchenbericht wurde für alle Patentansprüche erstellt.

| Recherchenort | Abschlußdatum der Recherche | Prüfer |
|---|---|---|
| DEN HAAG | 24-08-1982 | SCHUERMANS N.F.C. |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82